Europäisches Patentamt

(19) European Patent Office

Office européen des brevets

(11) Numéro de publication : **0 246 940 B1**

(12) **FASCICULE DE BREVET EUROPEEN**

(45) Date de publication du fascicule du brevet :
24.07.91 Bulletin 91/30

(51) Int. Cl.⁵ : **C30B 15/20, C30B 11/00**

(21) Numéro de dépôt : 87400938.4

(22) Date de dépôt : 23.04.87

(54) Procédé et dispositif de contrôle en continu de la surfusion du front de solidification d'un monocristal en cours d'elaboration et application au contrôle de la croissance d'un cristal.

(30) Priorité : 28.04.86 FR 8606107

(43) Date de publication de la demande :
25.11.87 Bulletin 87/48

(45) Mention de la délivrance du brevet :
24.07.91 Bulletin 91/30

(84) Etats contractants désignés :
CH DE GB IT LI NL

(56) Documents cités :
JOURNAL OF CRYSTAL GROWTH, vol. 42, no. 1, décembre 1977, pages 499-502, North-Holland Publishing Co.; J.R. OWEN et al.: "Thermoelectric monitoring of the interface temperature during czochralski growth of InSb"

(73) Titulaire : COMMISSARIAT A L'ENERGIE ATOMIQUE Etablissement de Caractère Scientifique Technique et Industriel
31/33, rue de la Fédération
F-75015 Paris (FR)

(72) Inventeur : Comera, Jean
La Faurie Venon
F-38610 Gieres (FR)
Inventeur : Contamin, Pierre
Montée de la Croix Blanche
F-38640 Claix (FR)
Inventeur : Favier, Jean-Jacques
12, Avenue Alsace Lorraine
F-38000 Grenoble (FR)
Inventeur : Marquet, Guy
166, Avenue Victor Hugo
F-38170 Seyssinet (FR)

(74) Mandataire : Mongrédien, André et al
c/o BREVATOME 25, rue de Ponthieu
F-75008 Paris (FR)

EP 0 246 940 B1

## Description

La présente invention a pour objet un procédé et un dispositif pour mesurer en continu l'écart de température dû à la surfusion au front de solidification d'un monocristal en cours d'élaboration et trouve une application intéressante au contrôle de la croissance cristalline, notamment au contrôle de la composition d'un monocristal dopé au cours de l'élaboration de celui-ci.

La croissance cristalline à partir d'un bain fondu est l'une des techniques les plus utilisées pour l'élaboration de cristaux métalliques ou semi-conducteurs de qualité.

Les deux propriétés les plus recherchées sont la qualité cristalline et l'homogénéité de composition, ce qui implique le contrôle du dopage ou de la répartition des impuretés résiduelles. Les méthodes de croissance cristalline les plus répandues sont la méthode de tirage de Czochralski, les méthodes de Bridgman, de Stockbarger horizontale ou verticale, la méthode de zone flottante et la fusion de zone. Cependant, à l'heure actuelle, aucune de ces méthodes ne permet de suivre en continu la concentration du cristal qui se forme lorsque le matériau est opaque (ce qui est le cas des métaux et des semi-conducteurs lorsqu'ils se trouvent à l'état liquide). Les analyses sont obligatoirement faites a posteriori par une méthode destructive, telle que les analyses chimiques ou électriques. Le procédé décrit dans l'article "Thermoelectric monitoring of the interface temperature during Czochralski growth of in Sb", J.R. Owen et al, paru dans Journal of crystal Growth, vol. 42, no. 1, (1987), pages 500-502, ne permet pas d'éviter ces inconvénients.

La présente invention a pour but de remédier à ces inconvénients en proposant un procédé et un dispositif qui permettent de contrôler la composition d'un cristal au fur et à mesure de son élaboration sans perturber cette dernière.

Pour cela, l'invention propose un procédé de contrôle en continu de la surfusion du front de solidification d'un monocristal en cours d'élaboration à partir d'une masse de matériau, ce procédé comprenant les étapes suivantes consistant à :

(a) - mesurer la différence de potentiel entre deux points de la masse de matériau situés de part et d'autre du front de solidification, dont l'un se trouve au même potentiel que le cristal et l'autre au même potentiel qu'une partie solide de la masse de matériau séparée du liquide par une interface fixe différente du front de solidification, et

(b) - déterminer l'écart de température T dû à la surfusion à partir de la différence de potentiel ainsi mesurée.

On rappelle que, du fait que le front de solidification d'un cristal en cours d'élaboration est mobile, il règne à cette interface une surfusion, c'est-à-dire que la température de l'interface est inférieure à la température de fusion/solidification du matériau. L'écart de température $\Delta T$ dû à la surfusion est la différence entre la température de fusion/solidification du matériau et la température réelle du front de solidification. L'expression "interface mobile" signifie que celle-ci (c'est-à-dire le front de solidification) est mobile par rapport à un point de la masse de matériau déjà solidifiée. En effet, cette interface peut être mobile par rapport au creuset si on déplace celui-ci dans un four où règne un gradient thermique de sorte que le front de solidification se trouve toujours au même emplacement dans le four (méthode de Bridgman) ou si on déplace les moyens de chauffage par rapport au creuset (fusion de zone). Cependant, dans des méthodes telles que la méthode de tirage de Czochralski, l'interface peut être fixe à la fois par rapport au creuset et par rapport aux moyens de chauffage permettant de créer un gradient thermique. Cependant, comme la longueur de la partie solide ne cesse d'augmenter, la distance entre un point du cristal déjà formé (ou un point du germe) et l'interface ne cesse d'augmenter : on peut donc considérer que l'interface est mobile par rapport à un point du cristal déjà formé. L'écart de température $\Delta T$ dû à la surfusion au front de solidification est relié à la différence de potentiel mesurée entre deux points situés de part et d'autre de l'interface par la relation $\Delta V = \alpha \Delta T$ dans laquelle $\alpha$ est le coefficient Seebeck de la jonction liquide-solide. Il est donc facile de déterminer $\Delta T$ à partir de $\Delta V$ connaissant le coefficient Seebeck du matériau.

Le procédé peut comporter une étape supplémentaire, effectuée après l'étape (b) consistant à déterminer la température T du front de solidification à partir de l'écart de température $\Delta T$ dû à la surfusion en utilisant la relation $T = T_f - \Delta T$ dans laquelle $T_f$ est la température de fusion du matériau.

On peut également agir sur les paramètres d'élaboration pour amener l'écart de température $\Delta T$ dû à la surfusion à la valeur désirée. Les paramètres sur lesquels on peut agir sont essentiellement la température et le gradient thermique régnant à l'intérieur du four et la vitesse de croissance du cristal, c'est-à-dire la vitesse à laquelle l'interface se déplace par rapport à un point du cristal déjà formé.

Dans la suite de la présente description, l'interface fixe différente du front de solidification sera appelée "interface de référence" parce qu'elle est fixe et se trouve à la température de fusion/solidification $T_f$ du matériau.

Selon un autre aspect du procédé objet de l'invention, on contrôle en continu la différence de température entre les deux points entre lesquels on mesure la différence de potentiel, ces points étant appelés "points de prise de potentiel" dans la suite de la présente description. De préférence, on fait en sorte que ces deux points soient à la même température, c'est-à-dire que la différence mesurée soit nulle.

Cependant, s'il y a une différence de température entre ces deux points, ceci n'est pas gênant et on en tient compte dans la détermination de l'écart de température ΔT à partir de la différence de potentiel mesurée.

L'invention a également pour objet un procédé de contrôle de la croissance d'un monocristal en cours d'élaboration à partir d'une masse de matériau, applicable essentiellement au cas où le matériau contient un élément d'addition, par exemple un dopant. Selon la principale caractéristique de ce procédé, celui-ci comprend les étapes suivantes consistant à :

- déterminer l'écart de température ΔT dû à la surfusion par le procédé décrit ci-dessus,
- déterminer la concentration en dopant à partir de l'écart de température ΔT dû à la surfusion ainsi déterminé, et
- agir sur les paramètres d'élaboration afin d'amener l'écart de teppérature ΔT dû à la surfusion à la valeur désirée.

Si l'on désigne par C l'écart de concentration en dopant entre le cristal en train de se former et la concentration qu'il aurait s'il était à la température de fusion, on a ΔT=mΔC, m étant la pente du liquidus dans le diagramme de phase. Le procédé permet donc de connaître la concentration en dopant ou en élément d'addition du cristal qui se forme par la détermination de la différence de potentiel ΔV de part et d'autre du front de solidification. En effet, à partir de ΔV, on peut déterminer l'écart de température ΔT dû à la surfusion connaissant le coefficient Seebeck du matériau et, à partir de ΔT, on peut déterminer l'écart de concentration grâce au diagramme de phase. On peut donc agir sur les paramètres d'élaboration du cristal (température, gradient thermique, vitesse d'élaboration...) afin de modifier ΔT, et donc ΔC. On peut ainsi maîtriser en continu la concentration du cristal en agissant sur les paramètres d'élaboration pour que cette concentration ait la valeur désirée. Suivant les cas, on peut soit la maintenir constante, soit la faire varier d'une extrémité à l'autre du monocristal.

L'invention a également pour objet un dispositif pour la mise en oeuvre de ce procédé, ce dispositif comprenant, de manière connue, des moyens pour créer un front de solidification dans la masse de matériau. Selon l'invention, ce dispositif comporte en outre :

- des moyens pour créer une interface fixe, différente du front de solidification, entre le liquide et une partir solide de la masse de matériau différente du cristal, et
- des moyens pour mesurer la différence de potentiel entre deux points dont l'un se trouve au même potentiel que le cristal et l'autre au même potentiel que ladite partie solide de la masse de matériau.

Les moyens pour créer une interface fixe peuvent comprendre :

- un premier four fixe,
- un creuset, fixe par rapport à ce premier four, et contenant la masse de matériau, ce creuset traversant une paroi du premier four de sorte qu'une partie du creuset se trouve à l'intérieur du premier four et une autre à l'extérieur,
- des moyens de chauffage équipant le premier four et aptes à chauffer la partie du creuset située à l'intérieur de ce premier four, et
- des premiers moyens de refroidissement pour refroidir la partie du creuset située à l'extérieur du premier four.

Dans ce cas, les moyens pour créer un front de solidification peuvent comprendre :

- un deuxième four, mobile par rapport au premier et par rapport au creuset, ce dernier traversant une paroi du deuxième four de sorte qu'une partie du creuset se trouve à l'intérieur du deuxième four et une autre partie à l'extérieur du deuxième four,
- des moyens de chauffage équipant le deuxième four et aptes à chauffer la partie du creuset située à l'intérieur de ce deuxième four,
- des deuxièmes moyens de refroidissement pour refroidir la partie du creuset située à l'extérieur du deuxième four, et
- des moyens d'entraînement simultané du deuxième four et des deuxièmes moyens de refroidisement.

De péférence, dans ce cas, l'agencement est tel que la partie du creuset se trouvant à l'intérieur du premier four est la même que celle se trouvant à l'intérieur du deuxième four ; les deux fours et les moyens de chauffage sont agencés de sorte que la partie de la masse de matériau contenue dans cette partie du creuset soit entièrement liquide. De plus, dans ce mode de réalisation préféré, la partie du creuset située à l'extérieur du premier four et la partie du creuset située à l'extérieur du deuxième four sont différentes et situées de part et d'autre de la partie contenant la masse liquide. Le réglage convenable des différents moyens de chauffage et de refroidissement permet de créer un gradient thermique dans la masse de matériau contenue dans le creuset et, en particulier, de régler la position du front de solidification et de la deuxième interface fixe.

Selon un autre aspect de ce dispositif, les moyens d'entraînement simultané du deuxième four et des deuxièmes moyens de refroidissement comprennent :

- un support sur lequel reposent le deuxième four et les deuxièmes moyens de refroidissement,
- une tige filetée mobile en rotation et immobilisée en translation,
- un écrou, solidaire du support, par l'intermédiaire duquel le support est monté sur la tige filetée, cet écrou étant immobilisé en rotation et mobile en translation, et

– des moyens de mise en rotation de la tige filetée.

Les moyens de mise en rotation de la tige filetée peuvent comprendre un moteur relié à celle-ci par un système d'engrenages.

Toujours dans le mode de réalisation décrit ici, le dispositif peut comporter en outre des moyens, montés sur le support, pour faire varier la position relative du deuxième four et des deuxièmes moyens de refroidisement. Ainsi, en éloignant ou en rapprochant le deuxième four et les deuxièmes moyens de refroidissement, on peut modifier le gradient thermique du matériau se trouvant à l'intérieur du creuset et faire varier la position du front de solidification.

Selon un autre aspect de ce dispositif, celui-ci peut comprendre des moyens pour contrôler la différence de température entre les points de prise de potentiel, ces moyens de contrôle comprenant par exemple :

– un premier microfour contenant ta partie de la masse de matériau où se trouve l'un des points de prise de potentiel,

– un premier thermocouple mesurant la température de ce point,

– un deuxième microfour contenant la partie de la masse de matériau où se trouve l'autre point de prise de potentiel,

– un deuxième thermocouple mesurant la température de ce deuxième point, et

– des moyens de régulation de la température de chaque microfour.

De préférence, les thermocouples sont montés en opposition de sorte qu'ils fournissent un signal correspondant à la différence de température entre les points de prise de potentiel. De préférence, on règle les moyens de chauffage des microfours afin que les deux points de prise de potentiel soient à la même température, c'est-à-dire que le signal fourni soit nul. Cependant, le procédé de l'invention peut encore être mis en oeuvre même si les deux points ne sont pas à la même température : dans ce cas, on tient compte de cette différence dans le calcul de la surfusion car le coefficient de Seebeck entre le matériau et le métal de la connexion de mesure de potentiel est soit connu, soit mesurable.

L'invention sera mieux comprise à la lecture de la description qui va suivre, donnée à titre d'exemple purement illustratif et nullement limitatif, en référence aux dessins annexés dans lesquels :

– la figure 1a est une vue schématique en coupe verticale d'un mode de réalisation du dispositif objet de l'invention,

– la figure 1b est un graphique montrant le profil longitudinal de température à l'intérieur de la masse de matériau,

– la figure 2 est une courbe représentant l'évolution de l'écart de température dû à la surfusion au front de solidification en fonction du temps au cours de l'élaboration du cristal, et

– la figure 3 est un graphe donnant, en fonction du temps, la température de l'un des fours utilisés dans le dispositif d'élaboration et celle du front de solidification, montrant comment on peut réduire les variations parasites de la température du front de solidification en modifiant la températurr du four.

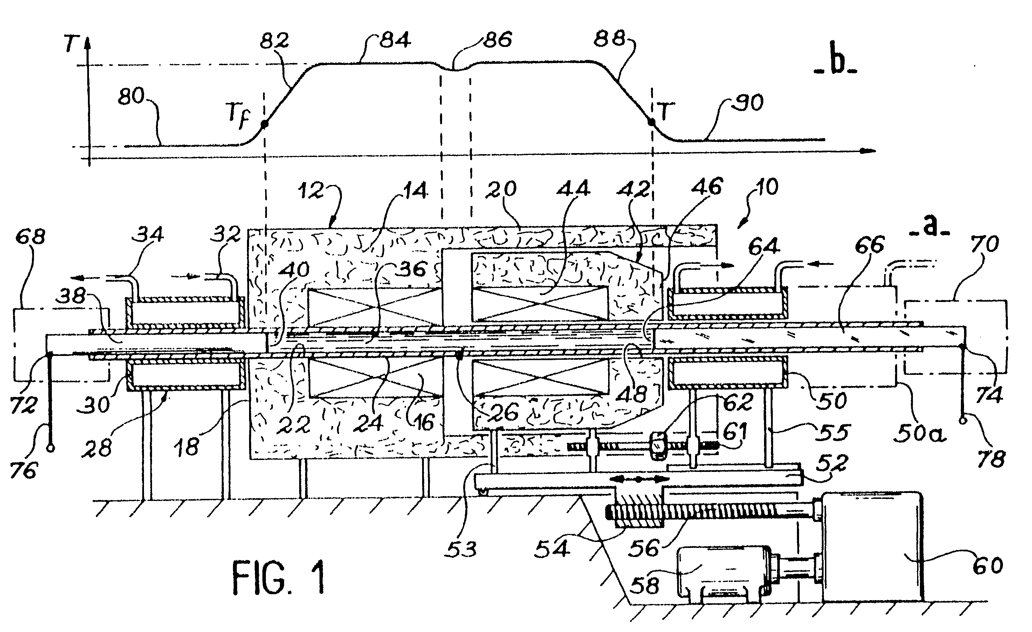

Si l'on se reporte à la figure 1a, on voit que le dispositif de l'invention, portant la référence générale 10, se compose d'abord d'un premier four 12 de forme sensiblement cylindrique et d'axe horizontal. Le four 12 se compose d'une première partie 14 comprenant les moyens de chauffage 16 et fermée, du côté gauche en regardant la figure, par une paroi isolante 18. La partie 14 du four se prolonge du côté droit en regardant la figure par un manchon 20 cylindrique de même axe que le four mais ouvert à son extrémité opposée aux moyens de chauffage 16, ces derniers se trouvant tout près de la paroi 18. Cette dernière est percée d'un orifice 22 disposé sensiblement suivant l'axe du four 12 et permettant le passage d'un creuset 24, lequel contient la masse de matériau 26 servant à l'élaboration du monocristal. On voit donc qu'une partie du creuset 24 se trouve à l'intérieur du four 12 et est chauffée par les moyens de chauffage 16, tandis qu'une autre partie du creuset se trouve à l'extérieur du four et elle est refroidie par des premiers moyens de refroidissement 28. Ceux-ci peuvent consister en une boîte à eau 30 entourant le creuset et étant en contact thermique avec lui, la boîte à eau 30 étant parcourue par de l'eau ou un autre fluide de refroidissement arrivant par une canalisation 32 et partant par une canalisation 34. Les moyens de chauffage 16 permettent d'obtenir à l'intérieur du four une température telle que la partie de la masse de matériau 26 se trouvant à cet endroit fonde et constitue la masse liquide 36 tandis que les moyens de refroidissement 28 permettent de maintenir à l'état solide une autre partie 38 du matériau. Il se crée donc un gradient thermique dans la masse de matériau entre l'intérieur du four 12 et l'extérieur de celui-ci, ce qui permet d'obtenir l'interface de référence 40 qui, dans l'exemple décrit ici, se trouve dans la partie du creuset située dans l'orifice 22.

Un deuxième four 42, de forme sensiblement cylindrique, est placé à l'intérieur du premier four 12, plus précisément à l'intérieur du manchon 20, les axes des deux fours étant sensiblement confondus. Le deuxième four 42 est équipé de moyens de chauffage 44. Ce four 42 présente, à sa partie la plus éloignée de la paroi 18 constituant le fond du four 12, une paroi 46 elle-même percée d'un orifice 48 sensiblement suivant l'axe du four 42. L'orifice 48 permet le passage du creuset 24 de sorte qu'une partie de celui-ci se trouve à l'intérieur du four 42 et une autre partie à l'extérieur de ce dernier. La partie du creuset 24 se trouvant à l'extérieur du four 42 est différente de celle qui se trouve à l'extérieur du four 12. Elle peut être refroidie par un dispositif de refroidissement 50 identique au dispositif 28 déjà décrit. L'action combinée des moyens de chauffage 44 du four 42 et du dispositif de refroidissement 50 permet de créer un gradient thermique dans la masse de matériau 26. Il est possible de faire en sorte que la partie située à l'intérieur du four 42 soit à l'état liquide et que la partie située à l'extérieur et refroidie par le dispositif 50 soit à l'état solide. Il est à remarquer que les parties liquides se trouvant à l'intérieur des fours 12 et 42 respectivement ne forment qu'une seule et même masse liquide 36. En effet, on peut voir sur la figure que la partie du creuset située entre les moyens de chauffage 16 et 44 n'est pas directement chauffée par ceux-ci. De plus, la longueur correspondante du creuset est variable puisque l'ensemble constitué par le four 42 et le dispositif de refroidissement 50 est mobile par rapport au premier four. Cependant, cette zone est entourée par le manchon isolant 20 et elle est chauffée indirectement par les moyens de chauffage 16 et 44. La température du matériau à cet endroit est inférieure à ce qu'elle est au niveau des moyens de chauffage 16 et 44. Cependant, on peut régler ces derniers de sorte que, même si la partir intermédiaire du creuset est à une température inférieure à ce qu'elle est au voisinage immédiat des moyens de chauffage, le matériau soit encore liquide à cet endroit.

On voit encore sur la figure la que le four mobile 42 et le dispositif de refroidissement 50 reposent l'un et l'autre sur un support 52. Celui-ci est équipé d'un écrou 54 monté sur une tige filetée 52. Cette dernière est immobilisée en translation mais mobile en rotation tandis que l'écrou 54 (et donc le support 52) est immobilisé en rotation mais mobile en translation. La tige 56 est entraînée en rotation grâce à un moteur 58 par l'intermédiaire d'un mécanisme d'entraînement placé à l'intérieur d'un boîtier 60, par exemple un mécanisme à engrenages. Une autre tige filetée 61, munie d'un écrou 62, permet d'éloigner plus ou moins le four 42 et le dispositif de refroidissement 50 l'un de l'autre. Ceci permet de faire varier la position du front de solidification 64. Il est à noter que le support 52 se trouve à l'extérieur du manchon 20 du four 12. On a prévu, sensiblement suivant la génératrice inférieure du manchon 20, une fente permettant le passage des pieds 53, 55 par lesquels le four 42 et le dispositif de refroidissement 50 reposent sur le support 52. Cependant, les déperditions de chaleur sont limitées car la largeur de la fente est faible par rapport au diamètre du manchon 20.

On voit encore sur la figure que les extrémités, opposées à la masse liquide 36, de la partie solide 38 d'une part et du cristal 66 d'autre part, se trouvent à l'intérieur de deux microfours 68 et 70 respectivement, ces derniers étant représentés schématiquement en traits mixtes sur le dessin. C'est à l'intérieur de ces microfours que se trouvent les points de prise de potentiel 72 et 74. Deux thermocouples 76 et 78 permettent de connaître la température en chacun de ces points.

La figure 1b représente le profil de température à l'intérieur de la masse de matériau. Du côté gauche de la figure, une première partie 80 de la courbe correspond à un palier horizontal et donc à une température constante et relativement basse qui est celle de la masse solide 38 refroidie par le dispositif 28. Puis, la température augmente régulièrement (partie 82 de la courbe) et passe par la température de fusion $T_f$ du matériau au niveau de l'interface 40. On a ensuite un palier 84 à une température supérieure à $T_f$. Le palier 84 comporte un creux 86 correspondant à une chute de température dans la partie de la masse liquide 36 située entre les moyens de chauffage 16 et 44 des fours 12 et 42 respectivement. Cette chute est d'autant plus importante que les deux fours sont plus éloignés l'un de l'autre. Cependant, on règle les moyens de chauffage pour que la totalité de la masse 36 reste liquide quelle que soit la position relative des deux fours. La température diminue ensuite (partie 88 de la courbe) et passe, au niveau de l'interface 64, par une valeur T qui n'est pas égale à la température de fusion du matériau, mais à $T_f$-$\Delta T$, $\Delta T$ étant l'écart de température dû à la surfusion. On arrive ensuite à un palier 90, qui peut être à la même température que le palier 80, et qui correspond au cristal 66 déjà formé, celui-ci étant refroidi par le dispositif 50.

Le fonctionnement du dispositif de la figure 1 est le suivant :

Au départ, on déplace le support 52 vers la droite en regardant la figure afin d'éloigner le four 42 des moyens de chauffage 16 du four 12. Le dispositif de refroidissement 50 occupe alors la position 50a représentée en traits mixtes sur le dessin. On introduit alors le creuset dans les orifices 22 et 48 des deux fours ainsi que dans les orifices centraux des boîtes à eau des moyens de refroidissement 30 et 50. On introduit le matériau à élaborer à l'état solide (par exemple sous la forme d'une barre), de sorte qu'il remplisse complètement le creuset et dépasse chacune des extrémités de celui-ci. On place ensuite les microfours 68 et 70 de sorte qu'ils contiennent les extrémités du creuset et du matériau à élaborer et on installe les thermocouples 76 et 78. On met en route les moyens de chauffage 16 et 44 jusqu'à ce que la partie du matériau se trouvant à l'intérieur des deux fours soit entièrement à l'état liquide. Puis, le moteur 58 est mis en action afin que le support 52 se déplace de la droite vers la gauche en regardant la figure 1a. Comme le four 42 et le dispositif de refroidissement 50 sont fixes par rapport au support 52, ceci a pour effet de provoquer le déplacement de l'interface 64 et de provoquer la croissance du cristal 66.

La détermination de l'écart de température dû à la surfusion $\Delta T$ à l'interface 64 se fait de la manière suivante :

On mesure la différence de potentiel entre les points 72 et 74 situés dans la masse solide 38 et dans le cristal 66 respectivement. Il est à remarquer que le point 74 n'est pas nécessairement dans le cristal, mais peut être dans une partie solide non critallisée du matériau, le cristal ne commençant qu'à partir de l'endroit où se trouvait l'interface 64 lorsque le dispositif était en position de départ. De toute façon, le point 74 est au même potentiel que le cristal. A partir de la différence de potentiel ainsi mesurée, il est posible de déterminer $\Delta T$ connaissant le coefficient Seebeck du matériau. D'autre part, connaissant $\Delta T$, il est possible de connaître l'écart de concentration du dopant si on connaît la pente du liquidus du diagramme de phase à la température considérée. On peut donc agir sur la concentration du dopant en modifiant les paramètres d'élaboration (par exemple la vitesse d'élaboration, c'est-à-dire la vitesse de déplacement du support 52) afin de modifier $\Delta T$ et, par voie de conséquence, la concentration du dopant.

Il importe de noter que, dans l'invention, les deux points entre lesquels on mesure la différence de potentiel se trouvent bien de part et d'autre du front de solidification. Cependant, ces deux points se trouvent séparés non seulement par l'interface de solidification, mais aussi par une deuxième interface existant entre le liquide et une partie solide du matériau différente du cristal. Cette deuxième interface, appelée "interface de référence", est fixe. Au niveau de cette interface, il y a donc équilibre thermodynamique et la température de fusion $T_f$ est la température de fusion du matériau à l'équilibre thermodynamique (température de fusion "classique" donnée habituellement comme une des propriétés physiques du matériau).

L'interface de solidification est mobile. Il n'y a pas d'équilibre thermodynamique à cette interface, la température de fusion est une température de fusion du matériau hors équilibre thermodynamique ; elle est différente de $T_f$.

Si la différence de potentiel est mesurée entre un point du solide en cours de croissance et un point du liquide, l'interface de solidification est mobile. Il y a donc surfusion (surfusion dite "cinétique"). La température à l'interface de solidification est une température de fusion hors équilibre thermodynamique différente de $T_f$ (température de fusion du matériau à l'équilibre thermodynamique). La différence de potentiel entre ces deux points est l'image d'un écart de température relatif puisque la température de fusion hors équilibre thermodynamique prise en référence n'est pas connue ou fixée.

Dans la présente invention, la mesure est faite entre un point d'une partie solide du matériau et un point du cristal. Il existe deux interfaces : l'une est fixe et se trouve donc à l'équilibre thermodynamique, donc à une température $T_f$ parfaitement connue pour un matériau donné. L'autre est mobile, c'est l'interface de solidification. Elle est hors équilibre thermodynamique à une température de fusion du matériau T nécessairement différente de $T_f$. La différence $\Delta T = T_f - T$ est l'écart de température dû à la surfusion. Le cristal est au potentiel de l'interface de solidification, lequel est à la température T. Le liquide présente un état de surfusion "cinétique". La mesure entre les deux points se traduit par une différence de potentiel absolue puisque le potentiel du solide est égal au potentiel de l'interface fixe, interface se trouvant à une température connue $T_f$. C'est un potentiel de référence. L'écart $\Delta T$ ainsi mesuré est aussi une valeur absolue. On peut alors en déduire la température absolue de l'interface de solidification.

L'écart de température $\Delta T$ dû à la surfusion est l'écart de température entre les deux interfaces.

On peut également, en ajustant la température des fours 12 et 42 éviter les bruits de fond sur $\Delta T$, ce qui conduit à des stries indésirables dans le cristal terminé, comme cela sera exposé plus en détail ci-après.

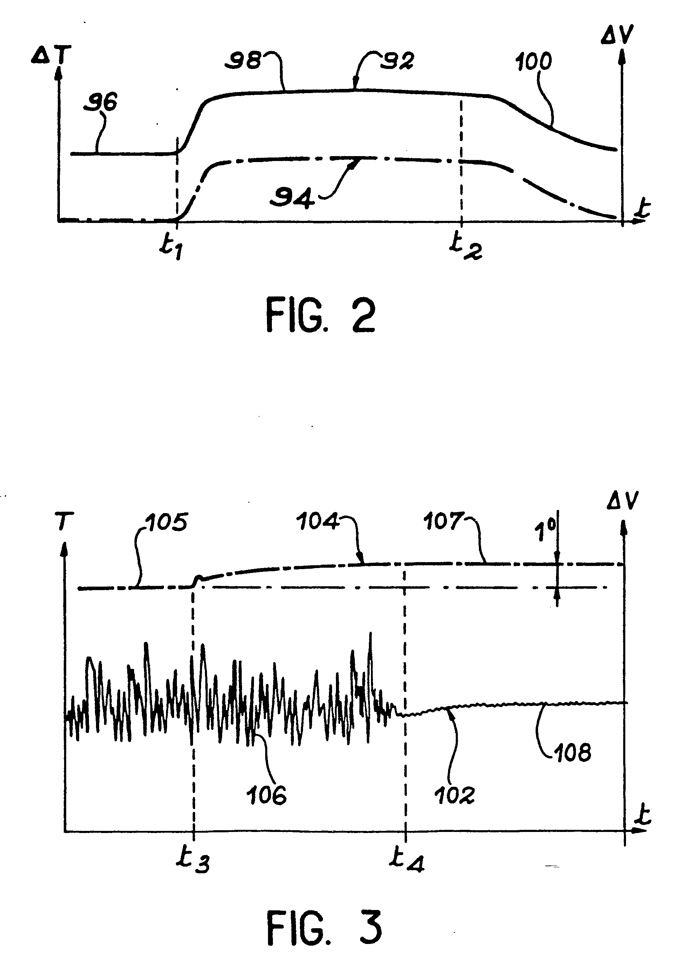

Sur la figure 2, on a représenté, en fonction du temps t, l'évolution du signal Seebeck $\Delta V$ (courbe 92) et l'évolution de l'écart de température $\Delta T$ au front de solidification (courbe 94). Il est à noter que, l'écart de température T étant proportionnel au signal Seebeck, les deux courbes ont la même allure. Au départ, lorsque le matériau contenu dans la partie centrale du creuset 24 est à l'état liquide, mais avant que le tirage ne soit commencé, le signal de Seebeck est nul et correspond au palier 96 sur la courbe 92. A partir de l'instant $t_1$ correspondant au début du tirage, ce signal évolue jusqu'à atteindre un palier 98 sensiblement horizontal et correspondant à une valeur constante pendant toute la durée du tirage si les paramètres d'élaboration restent constants. Le tirage est arrêté à l'instant $t_2$ et le signal décroît progressivement, ce qui correspond à la partie 100 de la courbe.

Il se peut, dans certains cas, qu'on note un bruit de fond important sur le signal de Seebeck. Ceci correspond à des variations de la température du front de solidification dues à des mouvements convectifs dans le liquide. Ces mouvements peuvent se produire aussi bien au sol qu'en microgravité spatiale et ils provoquent des variations de la concentration moyenne du liquide ainsi que des fluctuations locales de la concentration au niveau du front de solidification.

La figure 3 représente, à échelle agrandie, deux courbes donnant respectivement, en fonction du temps, le signal Seebeck $\Delta V$ (courbe 102) et la température du four 12 (courbe 104). La courbe 102 comporte une première zone 106 correspondant au début de l'expérience dans laquelle le bruit de fond est relativement important. On s'est aperçu qu'en modifiant la température T du four 12, on pouvait diminuer considérablement ce bruit de fond (partie 108 de la courbe 102).

Des essais ont été réalisés avec le dispositif de la figure 1a sur un alliage d'étain et de plomb contenant 800 ppm de plomb en atomes. On a réalisé un cristal de diamètre 4 mm et de 60 mm de longueur. La température de fusion/solidification du matériau est de 232°C, mais les fours 12 et 42 étaient réglés de manière à avoir une température de l'ordre de 688°C dans la zone centrale du creuset afin que le matériau reste liquide, même au moment de l'éloignement maximum des moyens de chauffage 16 et 44 des deux fours. Le gradient à l'interface de solidification était de 120°C par centimètre et la vitesse de tirage de 12 cm par heure. Les courbes de la figure 3 correspondent à cette expérience-là, et on s'est aperçu qu'au début du tirage on avait un bruit de fond important (partie 106 de la courbe 102) correspondant à des variations de l'ordre de 0,35°K sur l'écart de température $\Delta T$ dû à la surfusion. Ces variations peuvent être détectées grâce à un amplificateur du signal Seebeck. La température initiale du four 12 était de 687,3°C. A partir de l'instant $t_3$, on a modifié le réglage des moyens de chauffage du four afin d'augmenter sa température de 1°C. Lorsque la nouvelle température de 688,3°C a été atteinte (instant $t_4$), le bruit de fond sur $\Delta V$ a considérablement diminué (partie 108 de la courbe 102) et l'écart de température $\Delta T$ est resté constant à 0,01°K prés jusqu'à la fin de l'élaboration. Une fois le cristal terminé, on a constaté que la zone de celui-ci correspondant à la zone 106 de la courbe 102, dans laquelle le bruit de fond était important, présentait des striations importantes correspondant à une accumulation de défauts. L'autre zone de l'élément, correspondant à la partie 108 de la courbe 102, était exempte de striations.

L'invention présente des avantages particulièrement intéressants dont le principal est de permettre de contrôler en continu la croissance d'un cristal, notamment la composition de celui-ci lorsqu'il y a un dopant ou un élément d'addition, alors que les méthodes actuelles ne permettent pas ce contrôle. La méthode de l'invention ne perturbe pas le phénomène de solidification et de croissance cristalline car les points de prise de potentiel sont éloignés du front de solidification, et il n'est pas nécessaire d'introduire une sonde dans le cristal.

On peut vérifier la stationnarité de la croissance et, en particulier, visualiser les régimes transitoires de croissance qui sont souvent longs et conduisent à des macroségrégations. On peut aussi mesurer les fluctuations instantanées de la température du front de cristallisation qui sont liées aux instabilités hydrodynamiques dans le liquide ou qui sont d'origine cinétique. Ces variations sont à l'origine de striations ou de bandes dans les cristaux. On peut donc, en modifiant les conditions de croissance (température du four, gradient de température et vitesse de tirage) éviter ces striations et obtenir des cristaux homogènes. On peut enfin visualiser les instabilités morphologiques qui se développent à l'interface et sont à l'origine de ségrégations radiales dans les cristaux conduisant à des structures cellulaires et dendritiques. On peut les éviter, par exemple en augmentant le gradient de température au front de solidification.

De plus, l'invention s'applique aussi bien pour des études en laboratoire que pour des réalisations industrielles. On peut par exemple prévoir une boucle de régulation qui asservit la température du four en la modifiant de quelques degrés dès que des instabilités telles que celles précédemment décrites sont signalées par l'amplificateur du signal Seebeck. Par exemple, comme on l'a montré précédemment, on peut, en modifiant la température du four d'une valeur faible, de l'ordre de 1°C, éviter l'installation d'un mode convectif oscillant dans le liquide. Ces mouvements convectifs sont à l'origine d'oscillations du signal de Seebeck et conduisent à la formation de bandes dans le cristal.

Cette méthode de mesure et de régulation de la température du front de solidification permet d'optimiser les conditions de croissance des cristaux métalliques et semi-conducteurs et s'applique à toutes les techniques connues de croissance cristalline, notamment pour réaliser des cristaux homogènes. L'invention s'applique aussi bien au sol qu'en microgravité spatiale, par exemple dans un satellite. Enfin, l'analyse de la concentration axiale le long des cristaux élaborés peut se faire à la simple lecture du signal Seebeck en cours d'élaboration si la diffusion à l'état solide n'a pas conduit à une évolution de profil. C'est en général le cas puique les coefficients de diffusion à l'état solide sont en général de l'ordre de $10^{-9}$ à $10^{-11}$ cm$^2$/s. La méthode de l'invention est donc aussi une méthode d'analyse non-destructive de la concentration en dopant du cristal au fur et à mesure de l'élaboration de celui-ci.

**Revendications**

1. Procédé de contrôle en continu de la surfusion du front de solidification (64) d'un monocristal (66) en cours d'élaboration à partir d'une masse de matériau, lequel procédé comprend les étapes suivantes consistant à :

   (a) mesurer la différence de potentiel entre deux points (72, 74) de la masse de matériau situés de part et d'autre du front de solidification (64), dont l'un (74) se trouve au même potentiel que le cristal (66) et l'autre (72) au même potentiel qu'une partie solide (38) de la masse de matériau séparée de liquide (36) par une interface fixe (40) différente du front de solidification (64), et

   (b) déterminer l'écart de température ($\Delta T$) dû à la surfusion à partir de la différence de potentiel ainsi mesurée.

2. Procédé selon la revendication 1, caractérisé en ce qu'il comporte une étape supplémentaire, effectuée après l'étape (b), consistant à déterminer la température du front de solidification (64) à partir de l'écart de température (ΔT) dû à la surfusion.

3. Procédé selon la revendication 1, caractérisé en ce qu'il comporte une étape supplémentaire, effectuée après l'étape (b), consistant à agir sur les paramètres d'élaboration pour amener l'écart de température (ΔT) dû à la surfusion à la valeur désirée.

4. Procédé selon la revendication 1, caractérisé en ce que l'on contrôle en continu la différence de température entre les deux points de prise de potentiel (72, 74).

5. Procédé de contrôle de la croissance d'un monocristal en tours d'élaboration à partir d'une masse de matériau, caractérisé en ce qu'il comprend les étapes suivantes consistant à :

déterminer l'écart de température (ΔT) dû à la surfusion par le procédé selon la revendication 1,

déterminer la concentration en dopant à partir de l'écart de température ainsi déterminé, et

agir mur les paramètres d'élaboration afin d'amener l'écart de température (ΔT) dû à la surfusion à la valeur désirée.

6. Dispositif pour la mise en oeuvre du procédé selon la revendication 1, comprenant des moyens pour créer un front de solidification (64) dans la masse de matériau, et en outre :

des moyens pour créer une interface fixe (40), différente du front de solidification (64), entre le liquide (36) et une partie solide (38) de la masse de matériau différente du cristal, et

des moyens pour mesurer la différence de potentiel entre deux points dont l'un (74) se trouve au même potentiel que le cristal (66) et l'autre (72) au même potentiel que ladite partie solide (38) de la masse de matériau.

7. Dispositif selon la revendication 6, caractérisé en ce que lesdits moyens pour créer une interface fixe (40) comprennent :

un premier four fixe (12),

un creuset (24) contenant la masse de matériau et traversant une paroi (18) du premier four de sorte qu'une partie du creuset se trouve à l'intérieur du premier four et une autre à l'extérieur,

des moyens de chauffage (16) équipant le premier four et aptes à chauffer la partie du creuset située à l'intérieur du premier four, et

des premiers moyens de refroidissement (28) de la partie du creuset située à l'extérieur du premier four.

8. Dispositif selon la revendication 7, caractérisé en ce que les moyens pour créer un front de solidification (64) comprennent :

un deuxième four (42) mobile par rapport au premier et par rapport au creuset (24), le creuset traversant une paroi (46) de ce deuxième four (42) de sorte qu'une partie du creuset se trouve à l'intérieur du deuxième four (42) et une autre partie à l'extérieur du deuxième four,

des moyens de chauffage (44) équipant le deuxième four (42) et aptes à chauffer la partie du creuset située à l'intérieur du deuxième four,

des deuxièmes moyens de refroidissement (50) de la partie du creuset située à l'extérieur du deuxième four (42), et

des moyens d'entraînement simultané du deuxième four (42) et des deuxièmes moyens de refroidissement (50).

9. Dispositif selon la revendication 8, caractérisé en ce que lesdits moyens d'entraînement comprennent :

un support (52) sur lequel reposent le deuxième four (42) et les deuxièmes moyens de refroidissement (50),

une tige filetée (56) mobile en rotation et immobilisée en translation,

un écrou (54), solidaire du support (52), par l'intermédiaire duquel le support (52) est monté sur la tige filetée (56), cet écrou étant immobilisé en rotation et mobile en translation, et

des moyens de mise en rotation de la tige filetée (56).

10. Dispositif selon la revendication 9, caractérisé en ce qu'il comporte en outre des moyens, montés sur le support (52), pour faire varier la position relative du deuxième four (42) et des deuxièmes moyens de refroidissement (50).

11. Dispositif selon la revendication 6, caractérisé en ce qu'il comprend des moyens pour contrôler la différence de température entre les points (72, 74) de prise de potentiel.

12. Dispositif selon la revendication 11, caractérisé en ce que lesdits moyens pour contrôler la différence de température entre les points (72, 74) de prise de potentiel comprennent :

un premier microfour (68) contenant la partie de la masse de matériau où se trouve l'un (72) des points de prise de potentiel,

un premier thermocouple (76) mesurant la température de ce premier point,

un deuxième microfour (70) contenant la partie de la masse de matériau où me trouve l'autre point de prise de potentiel (74),

un deuxième thermocouple (78) mesurant le température de ce deuxième point, et

des moyens de régulation de la température de chaque microfour.

**Patentansprüche**

1. Verfahren zum fortlaufenden Regeln der Unterkühlung der Erstarrungsfront (64) eines Einkristalls (66) im Verlaufe der Entwicklung aus einer Materialmasse, enthaltend die folgenden Schritte :

a) Messen der Potentialdifferenz zwischen zwei Punkten (72,74) der Materialmasse, die beiderseits der Erstarrungsfront (64) liegen, von denen der eine (74) sich auf dem gleichen Potential wie der kristall (66) befindet und der andere sich auf dem gleichen Potential wie ein fester Teil (38) der Materialmasse befindet, der von der Flüssigkeit (36) durch eine feste Grenzfläche (40) getrennt ist, die von der Erstarrungfront (64) verschieden ist, und

b) Bestimmen der Temperaturabweichung (ΔT) aufgrund der Unterkühlung aus der so gemessenen Potentialdifferenz.

2. Verfahren nach Anspruch 1, **dadurch gekennzeichnet,** daß es einen Zusatzschritt enthält, der nach dem Schritt (b) ausgeführt wird und darin besteht, die Temperatur der Erstarrungsfront (64) aus der durch die Unterkühlung hervorgerufenen Temperaturabweichung (ΔT) zu ermitteln.

3. Verfahren nach Anspruch 1, **dadurch gekennzeichnet,** daß es einen Zusatzschritt enthält, der nach dem Schritt (b) ausgeführt wird und darin besteht, auf die Entwicklungsparameter einzuwirken, um die durch die Unterkühlung hervorgerufene Temperaturabweichung auf einen gewünschten Wert zu bringen.

4. Verfahren nach Anspruch 1, **dadurch gekennzeichnet,** daß man die Temperaturdifferenz zwischen den zwei Potentialermittlungspunkten (72,74) kontinuierlich regelt.

5. Verfahren zur Regelung des Wachstums eines Einkristalls im Verlaufe seiner Entwicklung aus einer Materialmasse, **dadurch gekennzeichnet,** daß es die folgenden Schritt umfaßt :

Bestimmen der durch die Unterkühlung hervorgerufenen Temperturabweichung (ΔT) gemäß dem Verfahren nach Anspruch 1,

Bestimmen der Dotierungskonzentration aus der so bestimmten Temperaturabweichung, und

Einwirken auf die Entwicklungsparameter, um die durch die Unterkühlung hervorgerufene Temperaturabweichung (ΔT) auf den gewünschten Wert zu bringen.

6. Vorrichtung zur Ausführung des Verfahrens nach Anspruch 1, enthaltend Einrichtungen zum Erzeugen einer Erstarrungsfront (64) in der Matrialmasse und weiterhin :

Einrichtungen zum Erzeugen einer festen Grenzfläche (40), die von der Erstarrungsfront (64) verschieden ist, zwischen der Flüssigkeit (36) und einem festen Teil (38) der Materialmasse, der von dem kristall verschieden ist, und

Einrichtungen zum Messen der Potentialdifferenz zwischen zwei Punkten, von denen der eine (74) sich auf dem gleich Potential wie der Kristall (66) befindet und der andere (72) sich auf dem gleichen Potential wie der genannte feste Teil (38) der Materialmasse befindet.

7. Vorrichtung nach Anspruch 6, **dadurch gekennzeichnet,** daß die Einrichtungen zum Erzeugen einer festen Grenzfläche (40) enthalten :

einen ersten festen Ofen (12),

einen Schmelztiegel (24), der die Materialmasse enthält und der eine Wand (18) des ersten Ofens derart druchdringt, daß ein Teil des Schmelztiegels sich im Innern des ersten Ofens und der andere außerhalb befindet,

Heizeinrichtungen (16), mit denen der erste Ofen ausgerüstet ist und die dazu eingerichtet sind, den Teil des Schmelztiegels zu erhitzen, der sich im Innern des ersten Ofens befindet, und

erste Kühleinrichtungen (28) für den Teil des Schmelztiegels, der außerhalb des ersten Ofens gelegen ist.

8. Vorrichtung nach Anspruch 7, **dadurch gekennzeichnet,** daß die Einrichtungen zum Erzeugen einer Erstarrungsfront (64) enthalten :

einen zweiten Ofen (42), der gegenüber dem ersten und gegenüber dem Schmelztiegel (24) beweglich ist, wobei der Schmelztiegel eine Wand (46) des zweiten Ofens (42) derart durchdringt, daß ein Teil des Schmelztiegels sich im Innern des zweiten Ofens (42) und ein anderer Teil außerhalb des zweiten Ofens befindet,

Heizeinrichtungen (44), mit denen der zweite Ofen (42) ausgerüstet ist und die dazu eingerichtet sind, den Teil des Schmelztiegels zu erhitzen, der im Innern des zweiten Ofens gelegen ist,

zweite Kühleinrichtungen (50) für den Teil des Schmelztiegels, der außrhalb des zweiten Ofens (42) liegt, und

Einrichtungen zum gleichzeitigen Bewegen des zweiten Ofens (42) und der zweiten Kühleinrichtung (50).

9. Vorrichtung nach Anspruch 8, **dadurch gekennzeichnet,** daß die Bewegungseinrichtungen enthalten :

einen Trägeer (52), auf dem der zweite Ofen (42) und die zweiten Kühleinrichtungen (50) ruhen,

eine Gewindestange (56), die drehbeweglich und in Längsrichtung unbeweglich ist,

eine Mutter (54), die fest mit dem Träger (52) verbunden ist und mittels der der Träger (52) auf der Gewindestange (56) gehalten ist und die drehfest gehalten und in Längsrichtung beweglich ist, und

Einrichtungen zum Drehen der Gewindestange (56).

10. Vorrichtung nach Anspruch 9, **dadurch gekennzeichnet,** daß sie weiterhin Einrichtungen aufweist, die an dem Träger (52) befestigt sind, um die Relativposition des zweiten Ofens (42) und der zweiten Kühleinrichtungen (50) verstellen zu können.

11. Vorrichtung nach Anspruch 6, **dadurch gekennzeichnet,** daß sie Einrichtungen zum Regeln der Temperaturdifferenz zwischen den Potentialerfassungspunkten (72,74) aufweist.

12. Vorrichtung nach Anspruch 11, **dadurch gekennzeichnet**, daß die Einrichtungen zum Regeln der Temperaturdifferenz zwischen den Potentialerfassungspunkten (72,74) enthalten :

einen ersten Mikroofen (68), der den Teil der Materialmasse enthält, in dem sich der eine (72) der Potentialerfassungpunkte befindet,

ein erstes Thermoelement (76), das die Temperatur dieses ersten Punktes mißt,

einen zweiten Mikroofen (70), der den Teil der Materialmasse enthält, in dem sich der andere Potentialerfassungspunkt (74) befindet,

ein zweites Thermoelement (78), das die Temperatur dieses zweiten Punktes mißt, und

Regeleinrichtungen für die Temperatur jedes Mikroofens.

## Claims

1. Process for the continuous checking of the supermelting of the solidification front (64) of a monocrystal (66) during formation from a material mass, wherein said process comprises the following stages:

a) measuring the potential difference between two points (72, 74) of the material mass on either of the solidification front (64), one (74) being at the same potential as the crystal (66) and the other (72) at the same potential as a solid part (38) of the material mass separated from the liquid (36) by a fixed interface (40) differing from the solidification front (64), and

b) determining the temperature deviation ($\Delta T$) due to supermelting on the basis of the thus measured potential difference.

2. Process according to claim 1, characterized in that it involves a supplementary stage performed after stage (b) and consisting of the determining the temperature of the solidification front (64) on the basis of the temperature deviation ($\Delta T$) due to supermelting.

3. Process according to claim 1, characterized in that it comprises a supplementary stage performed after stage (b) and consisting of acting on the formation parameters for bringing the temperature deviation ($\Delta T$) due to the supermelting to the desired value.

4. Process according to claim 1, characterized in that continuous checking takes place of the temperature difference between the two potential taking points (72, 74).

5. Process for checking the growth of a monocrystal during formation from a material mass, characterized in that it comprises the following stages :

determining the temperature deviation ($\Delta T$) due to the supermelting by the process according to claim 1,

determining the dopant concentration on the basis of the thus determined temperature deviation, and

acting on the formation parameters in order to bring the temperature deviation ($\Delta T$) due to supermelting to the desired value.

6. Apparatus for performing the process according to claim 1, comprising means for producing a solidification front (64) in the material mass and also

means for producing a fixed interface (40), differing from the solidification front (64), between the liquid (36) and a solid part (38) of the material mass differing from the crystal and

means for measuring the potential difference between two points, whereof one (74) is at the same potential as the crystal (66) and the other (720) is at the same potential as the solid part (38) of the material mass.

7. Apparatus according to claim 6, characterized in that the means for producing a fixed interface (40) comprise :

a fixed first furnace (12),

a crucible (24) containing the material mass and traversing a wall (18) of the first furnace, in such a way that part of the crucible is within the first furnace and another part is outside it,

heating means (16) equipping the first furnace and able to heat that part of the crucible located within the first furnace, and

first cooling means (28) for that part of the crucible located outside the first furnace.

8. Apparatus according to claim 7, characterised in that the means for producing a solidification front (64) comprise :

a second furnace (42) which is mobile with respect to the first and with respect to the crucible (24), the crucible traversing a wall (46) of the second furnance (42), in such a way that part of the crucible is located within the second furnace (42) and the other part outside the second furnace,

heating means (44) equipping the second furnace (42) and able to heat that part of the crucible located within the second furnace,

second cooling means (50) for that part of the crucible located outside the second furnace (42), and

means for simultaneously driving the second furnace (42) and second cooling means (50).

9. Apparatus according to claim 8, characterized in that the said drive means comprise :

a support (52) on which rest the second furnace (42) and the second cooling means (50),

a threaded rod (56) mobile in rotation and immobilized in translation, a nut (54), integral with the support (52), via which the support (52) is mounted on the threaded rod (56), said nut being immobilized in rotation and mobile in translation, and

means for rotating the threaded rod (56).

10. Apparatus according to claim 9, characterized in that it also comprises means, mounted on the support (52), for varying the relative position of the second furnace (42) and second cooling means (50).

11. Apparatus according to claim 6, characterized in that it comprises means for checking the temperature difference between the potential taking points (72, 74).

12. Apparatus according to claim 11, characterized in that the means for checking the temperature difference between the potential taking points (72, 74) comprise :

a first microfurnace (68) containing that part of the material mass in which is located one (72) of the potential taking points,

a first thermocouple (76) measuring the temperature of said first point,

a second microfurnace (70) containing that part of the material mass where the other potential taking point (74) is located,

a second thermocouple (78) measuring the temperature of said second point, and

means for regulating the temperature of each microfurnace.

FIG. 1

-a-

-b-

FIG. 2

FIG. 3